(19) **Europäisches Patentamt**
**European Patent Office**
**Office européen des brevets**

(11) **EP 4 563 556 A1**

(12) **EUROPÄISCHE PATENTANMELDUNG**

(43) Veröffentlichungstag:
**04.06.2025   Patentblatt 2025/23**

(21) Anmeldenummer: **24214380.8**

(22) Anmeldetag: **21.11.2024**

(51) Internationale Patentklassifikation (IPC):
*C04B 37/02* (2006.01)   *C04B 41/53* (2006.01)
*H01L 21/306* (2006.01)   *C04B 41/00* (2006.01)

(52) Gemeinsame Patentklassifikation (CPC):
(C-Sets verfügbar)
**C04B 37/026; C04B 41/009; C04B 41/5346;
C04B 41/5353; H05K 3/00;** C04B 2237/127;
C04B 2237/368; C04B 2237/402; C04B 2237/407
(Forts.)

(84) Benannte Vertragsstaaten:
**AL AT BE BG CH CY CZ DE DK EE ES FI FR GB
GR HR HU IE IS IT LI LT LU LV MC ME MK MT NL
NO PL PT RO RS SE SI SK SM TR**
Benannte Erstreckungsstaaten:
**BA**
Benannte Validierungsstaaten:
**GE KH MA MD TN**

(30) Priorität: **30.11.2023   EP 23213373**

(71) Anmelder: **Heraeus Electronics GmbH & Co. KG
63450 Hanau (DE)**

(72) Erfinder:
• **Wacker, Richard
63450 Hanau (DE)**

• **Niewolak, Leszek
63450 Hanau (DE)**
• **Stoica, Stefanie
63450 Hanau (DE)**
• **Schnee, Daniel
63450 Hanau (DE)**
• **Schlüter, Bastian
63450 Hanau (DE)**

(74) Vertreter: **Heraeus IP
Heraeus Business Solutions GmbH
Intellectual Property
Heraeusstraße 12-14
63450 Hanau (DE)**

(54) **METALL-KERAMIK-VERBUND**

(57)    Die vorliegende Erfindung betrifft einen Metall-Keramik-Verbund, enthaltend
- ein Keramiksubstrat, das eine Vorderseite und eine Rückseite aufweist und $\beta$-Siliziumnitrid enthält,
- eine auf der Vorderseite des Keramiksubstrats vorliegende Metallbeschichtung,

wobei die Metallbeschichtung zumindest eine Aussparung aufweist und eine Oberfläche des Keramiksubstrats durch die Aussparung freigelegt ist,
wobei das Keramiksubstrat zumindest in dem Bereich der Aussparung der folgenden Bedingung genügt:

$$S_{O\text{-}\beta SN} / S_{B\text{-}\beta SN} \geq 0{,}8$$

wobei

$$S_{O\text{-}\beta SN} = I_{O\text{-}\beta SN}(101) / [0{,}5 \times (I_{O\text{-}\beta SN}(200) + I_{O\text{-}\beta SN}(120))]$$

$$S_{B\text{-}\beta SN} = I_{B\text{-}\beta SN}(101) / [0{,}5 \times (I_{B\text{-}\beta SN}(200) + I_{B\text{-}\beta SN}(120))]$$

$I_{O\text{-}\beta SN}(101)$, $I_{O\text{-}\beta SN}(200)$ und $I_{O\text{-}\beta SN}(120)$ die relativen Peakhöhen des (101)-, (200)- und (120)-Reflexes des $\beta$-Siliziumnitrids in einem Röntgenbeugungsdiffraktogramm, gemessen unter streifendem Einfall bei 3° mit Cu-K$\alpha$-Strahlung, sind, $I_{B\text{-}\beta SN}(101)$, $I_{B\text{-}\beta SN}(200)$ und $I_{B\text{-}\beta SN}(120)$ die relativen Peakhöhen des (101)-, (200)- und (120)-Reflexes des $\beta$-Siliziumnitrids in einem Röntgenbeugungsdiffraktogramm, gemessen mit Bragg-Brentano-Geometrie und Cu-K$\alpha$-Strahlung, sind.

EP 4 563 556 A1

(52) Gemeinsame Patentklassifikation (CPC): (Forts.)

    C-Sets
    **C04B 41/009, C04B 37/026**

**Beschreibung**

Die vorliegende Erfindung betrifft einen Metall-Keramik-Verbund, der als keramischer Schaltungsträger in der Leistungselektronik verwendbar ist.

In der Leistungselektronik müssen Leiterplatten als Träger von Leistungsbauteilen wie MOSFETs für hohe Ströme ausgelegt sein und Verlustwärme schnell abführen können.

Da keramische Materialien wie Aluminiumoxid, Aluminiumnitrid und Siliziumnitrid gegenüber Polymeren, die für die Herstellung herkömmlicher Leiterplatten verwendet werden, eine wesentlich höhere Wärmeleitfähigkeit aufweisen, werden in Leistungsmodulen häufig keramische Schaltungsträger verwendet.

Keramiksubstrate auf der Basis von Siliziumnitrid weisen eine sehr hohe mechanische Festigkeit bei gleichzeitig hoher Wärmeleitfähigkeit auf und sind daher sehr gut für Anwendungen in der Leistungselektronik geeignet.

Siliziumnitrid kann in einer als "α-Phase" oder einer als "β-Phase" bekannten Kristallstruktur vorliegen. Diese beiden Phasen unterscheiden sich in ihren Röntgenbeugungsdiffraktogrammen. Die bei den üblichen Sinterbedingungen stabile Phase ist die β-Phase (nachfolgend auch als β-Siliziumnitrid bezeichnet). Daher liegt in den siliziumnitridbasierten Keramiksubstraten üblicherweise β-Siliziumnitrid vor.

β-Siliziumnitrid enthält nadelförmige Kristallite. Es ist bekannt, dass die mechanischen Eigenschaften oder die Wärmeleitfähigkeit der Keramik durch die Ausrichtung dieser nadelförmigen β-Siliziumnitridkristallite im Keramikkörper beeinflussbar ist. Beispielsweise kann es für die mechanische Festigkeit der Keramik vorteilhaft sein, wenn die Mehrzahl der nadelförmigen Kristallite mit ihrer Längsachse im Wesentlichen parallel zur Keramikoberfläche orientiert sind, während es für die Wärmeleitfähigkeit eher vorteilhaft sein kann, wenn die Mehrzahl der nadelförmigen Kristallite mit ihrer Längsachse im Wesentlichen senkrecht zur Keramikoberfläche ausgerichtet sind.

T. Okuno et al., "Si3N4 Substrates with Anisotropic Thermal Conductivity Suitable for Power Module Applications", PCIM Europe digital days 2021; International Exhibition and Conference for Power Electronics, Intelligent Motion, Renewable Energy and Energy Management, Online, 2021, S. 1-5, beschreiben Keramiksubstrate, die jeweils β-Siliziumnitrid enthalten, wobei sich die Substrate in der Ausrichtung der länglichen β-Siliziumnitrid-Kristallite unterscheiden. Wenn die Anzahl der Kristallite, die mit ihrer Längsachse parallel zur Dickenrichtung (d.h. senkrecht zur Vorder- oder Rückseite) des Keramiksubstrats ausgerichtet sind, zunimmt, so nimmt auch die Intensität des (101)-Reflexes des β-Siliziumnitrids im Röntgenbeugungsdiffraktogramm zu.

Keramiksubstrate auf der Basis von Siliziumnitrid werden beispielsweise in folgenden Publikationen beschrieben:

N. Chasserio et al., "Ceramic Substrates for High-Temperature Electronic Integration", Journal of Electronic Materials, Band 38 (2009), S. 164-174;
K. Hirao et al., "High Thermal Conductivity Silicon Nitride Ceramics", Journal of the Korean Ceramic Society, Band 49 (2012), S. 380-384;
Y. Zhou et al., "Development of high-thermal-conductivity silicon nitride ceramics", Journal of Asian Ceramic Societies, 3 (2015), S. 221-229.

Eine Übersicht zu Methoden für die Herstellung von Siliziumnitridkeramiken mit unterschiedlichen Texturen findet sich beispielsweise in folgender Publikation:
X. Zhu und Y. Sakka, "Textured silicon nitride: processing and anisotropic properties", Sci. Technol. Adv. Mater., 9, 2008, 033001.

Siliziumnitridbasierte Keramiksubstrate, die einen guten Kompromiss zwischen hoher mechanischer Festigkeit und hoher Wärmeleitfähigkeit zeigen und in elektronischen Bauteilen verwendet werden können, sind kommerziell erhältlich.

Ein keramischer Schaltungsträger enthält ein Keramiksubstrat, das zumindest auf einer seiner Seiten, üblicherweise beidseitig mit einer Metallschicht versehen ist. Auf einer dieser Metallschichten sind im finalen Modul die Halbleiterbauelemente aufgebracht, während die Metallschicht auf der gegenüberliegenden Seite des Keramiksubstrats thermisch leitend mit einem Kühlkörper verbunden ist. Durch das Keramiksubstrat sind die Metallschichten elektrisch isoliert voneinander.

Die dem Fachmann bekannte Herstellung eines als keramische Leiterplatte fungierenden metallisierten Keramiksubstrats erfolgt beispielsweise, indem die Vorder- und Rückseite des Keramiksubstrats jeweils mit einer Metallfolie (z.B. einer Kupfer- oder Aluminiumfolie) in Kontakt gebracht und stoffschlüssig verbunden werden. Das stoffschlüssige Verbinden der Metallfolien erfolgt beispielsweise über ein eutektisches Bonden oder ein Aktivlöten (englisch: "*active metal brazing*", AMB). Ist die Metallfolie eine Kupferfolie, so wird das eutektische Bonding auch als DCB- oder DBC-Verfahren bezeichnet (DCB: "*Direct Copper Bonding*"; DBC: "*Direct Bonded Copper*"). Im Fall einer Aluminiumfolie wird beim eutektischen Bonding auch die Bezeichnung "DAB" ("*Direct Aluminum Bonding*") verwendet. Ein über ein DCB- oder AMB-Verfahren hergestelltes metallisiertes Keramiksubstrat wird gelegentlich auch als DCB-Substrat (alternativ: DBC-Substrat) oder AMB-Substrat bezeichnet.

Die Metallisierung von Siliziumnitridsubstraten erfolgt üblicherweise durch ein Aktivlöten.

Aktivlote enthalten neben einer Hauptkomponente wie z.B. Cu, Ag oder Au ein oder mehrere Elemente, die mit der Keramik unter Ausbildung einer haftvermittelnden Reaktionsschicht reagieren können (siehe z.B. Kapitel 8.2.4.3 ("Aktivlöten"), Seiten 203-204, in Brevier Technische Keramik, Verband der Keramischen Industrie e.V., 2003, Fahner Verlag). Als reaktive Elemente kommen beispielsweise Hafnium (Hf), Titan (Ti), Zirkonium (Zr), Niob (Nb), Cer (Ce), Tantal (Ta) und Vanadium (V) zum Einsatz. Bei der Metallisierung von Siliziumnitridsubstraten durch Aktivlöten enthält die Reaktionsschicht beispielsweise ein Nitrid, Oxynitrid und/oder Silicid des reaktiven Elements (A. Pönicke et al., "Aktivlöten von Kupfer mit Aluminiumnitrid- und Siliziumnitridkeramik", Keramische Zeitschrift, 63(5), 2011, 334-342).

Die die Halbleiterbauelemente tragende Metallschicht ist strukturiert (z.B. durch ein Ätzen). Die Strukturierung von AMB-Substraten kann beispielsweise in einem zweistufigen Verfahren erfolgen, wobei in einem ersten Schritt in definierten Bereichen zunächst die Metallschicht abgetragen wird (z.B. unter Verwendung einer ersten Ätzlösung) und anschließend in einem zweiten Schritt die aus dem Aktivlotverfahren resultierende Haftvermittlungsschicht entfernt wird (z.B. unter Verwendung einer zweiten Ätzlösung). Durch das Abtragen der Metallschicht in definierten Bereichen wird das Keramiksubstrat in diesen Bereichen wieder freigelegt.

In der Leistungselektronik verwendete Module auf der Basis keramischer Schaltungsträger können im Rahmen des "Packaging" beispielsweise verkapselt werden, indem das Leistungsmodul in eine Vergussmasse eingebettet wird.

Durch die Einbettung in eine Vergussmasse wird beispielsweise die elektrische Durchschlagsfestigkeit erhöht. Außerdem werden die Halbleiterbauelemente und metallischen Leiterbahnen vor Luftfeuchtigkeit geschützt und mechanisch stabilisiert.

In den durch die Strukturierung freigelegten Bereichen kommt das Keramiksubstrat in direkten Kontakt mit der Vergussmasse. Beim Betrieb eines Leistungsmoduls können erhebliche Temperaturschwankungen auftreten. Da keramische Materialien und die Vergussmasse üblicherweise deutlich unterschiedliche Wärmeausdehnungskoeffizienten aufweisen, führen diese Temperaturschwankungen zu mechanischen Spannungen an der Grenzfläche zwischen Keramik und Vergussmasse. Dies wiederum kann dazu führen, dass die Vergussmasse sich zumindest teilweise von dem Keramiksubstrat ablöst und Hohlräume entstehen. Luftfeuchtigkeit, die in diese Hohlräume eindringt, kann das Leistungsmodul schädigen. Außerdem kann es zumindest lokal zu einer signifikanten Reduzierung der elektrischen Durchschlagsfestigkeit kommen.

Wie oben bereits erwähnt, werden Keramiksubstrate auf der Basis von Siliziumnitrid aufgrund ihrer sehr hohen mechanischen Festigkeit bei gleichzeitig hoher Wärmeleitfähigkeit als Schaltungsträger in der Leistungselektronik verwendet. Um ihr Potential als Schaltungsträger möglichst umfassend zu nutzen, wäre es wünschenswert, dass nach einer Einbettung in eine Vergussmasse eine hohe Haftfestigkeit zwischen dieser Vergussmasse und der Siliziumnitridoberfläche vorliegt.

Eine Aufgabe der vorliegenden Erfindung ist die Bereitstellung eines metallisierten siliziumnitridhaltigen Keramiksubstrats, dessen freiliegende Oberfläche die Ausbildung einer Verbindung hoher Haftfestigkeit mit einer Vergussmasse ermöglicht.

Gelöst wird diese Aufgabe durch einen Metall-Keramik-Verbund, enthaltend

- ein Keramiksubstrat, das eine Vorderseite und eine Rückseite aufweist und $\beta$-Siliziumnitrid enthält,
- eine auf der Vorderseite des Keramiksubstrats vorliegende Metallbeschichtung, wobei die Metallbeschichtung zumindest eine Aussparung aufweist und eine Oberfläche des Keramiksubstrats durch die Aussparung freigelegt ist,

wobei das Keramiksubstrat zumindest in dem Bereich der Aussparung der folgenden Bedingung genügt:

$$S_{\text{O-}\beta\text{SN}} / S_{\text{B-}\beta\text{SN}} \geq 0{,}8$$

wobei

$$S_{\text{O-}\beta\text{SN}} = I_{\text{O-}\beta\text{SN}}(101) / [0{,}5 \times (I_{\text{O-}\beta\text{SN}}(200) + I_{\text{O-}\beta\text{SN}}(120))]$$

$$S_{\text{B-}\beta\text{SN}} = I_{\text{B-}\beta\text{SN}}(101) / [0{,}5 \times (I_{\text{B-}\beta\text{SN}}(200) + I_{\text{B-}\beta\text{SN}}(120))]$$

$I_{\text{O-}\beta\text{SN}}(101)$, $I_{\text{O-}\beta\text{SN}}(200)$ und $I_{\text{O-}\beta\text{SN}}(120)$ die relativen Peakhöhen des (101)-, (200)- und (120)-Reflexes des $\beta$-Siliziumnitrids in einem Röntgenbeugungsdiffraktogramm, gemessen unter streifendem Einfall bei 3° mit Cu-K$\alpha$-Strahlung, sind, wobei die relativen Peakhöhen auf die Peakhöhe des (200)-Reflexes normiert sind,
$I_{\text{B-}\beta\text{SN}}(101)$, $I_{\text{B-}\beta\text{SN}}(200)$ und $I_{\text{B-}\beta\text{SN}}(120)$ die relativen Peakhöhen des (101)-, (200)- und (120)-Reflexes des $\beta$-Siliziumnitrids in einem Röntgenbeugungsdiffraktogramm, gemessen mit Bragg-Brentano-Geometrie und Cu-K$\alpha$-Strahlung, sind, wobei die relativen Peakhöhen auf die Peakhöhe des (120)-Reflexes normiert sind.

Wie oben bereits erwähnt, wird die Intensität des (101)-Reflexes des β-Siliziumnitrids im Röntgenbeugungsdiffraktogramm durch die Ausrichtung der länglichen β-Siliziumnitrid-Kristallite beeinflusst. Wenn die Anzahl der Kristallite, die mit ihrer Längsachse parallel zur Dickenrichtung (d.h. senkrecht zur Vorder- oder Rückseite) des Keramiksubstrats ausgerichtet sind, zunimmt, so nimmt auch die Intensität des (101)-Reflexes und das Intensitätsverhältnis des (101)-Reflexes zu den (200)- und (120)-Reflexen des β-Siliziumnitrids im Röntgenbeugungsdiffraktogramm zu. Als Maß für die Intensitäten der Reflexe kann deren Peakhöhe im Röntgenbeugungsdiffraktogramm, normiert auf die Höhe eines Basispeaks, genommen werden.

Durch eine Röntgendiffraktometrie unter streifendem Einfall (englisch: "grazing incidence X-ray diffraction") wird gezielt die Struktur oberflächennaher Bereiche einer Probe untersucht, während eine Röntgendiffraktometrie mit Bragg-Brentano-Geometrie strukturelle Informationen liefert, die über das gesamte bestrahlte Volumen der Probe gemittelt sind.

Im Rahmen der vorliegenden Erfindung wurde überraschend erkannt, dass sich die Haftfestigkeit einer Vergussmasse auf dem Keramiksubstrat verbessern lässt, wenn das oben definierte Verhältnis (d.h. $S_{O-\beta SN} / S_{B-\beta SN} \geq 0{,}8$) erfüllt ist.

Beispielsweise gilt:

$$S_{O-\beta SN} / S_{B-\beta SN} \geq 0{,}95$$

In einer beispielhaften Ausführungsform ist folgende Beziehung erfüllt:

$$2{,}2 \geq S_{O-\beta SN} / S_{B-\beta SN} \geq 0{,}8$$

In einer weiteren beispielhaften Ausführungsform ist folgende Beziehung erfüllt:

$$2{,}2 \geq S_{O-\beta SN} / S_{B-\beta SN} \geq 0{,}95$$

In einer weiteren beispielhaften Ausführungsform ist folgende Beziehung erfüllt:

$$1{,}75 \geq S_{O-\beta SN} / S_{B-\beta SN} \geq 0{,}95$$

Wie nachfolgend noch eingehender beschrieben wird, lässt sich das erfindungsgemäße Verhältnis (d.h. $S_{O-\beta SN} / S_{B-\beta SN} \geq 0{,}8$) in dem Keramiksubstrat durch eine Bestrahlung mit einem gepulsten Laserstrahl, insbesondere einem Ultrakurzpulslaser, einstellen. Diese Behandlung scheint in einem oberflächennahen Bereich des Keramiksubstrats eine relative Zunahme an länglichen β-Siliziumnitridkristalliten, die mit ihrer Längsachse im Wesentlichen parallel zur Dickenrichtung (d.h. senkrecht zur Vorder- oder Rückseite) des Keramiksubstrats orientiert sind, zu bewirken. Dies führt wiederum dazu, dass der Wert für $S_{O-\beta SN}$ (d.h. $I_{O-\beta SN}(101) / [0{,}5 \times (I_{O-\beta SN}(200) + I_{O-\beta SN}(120))]$) eine stärkere Zunahme zeigt als der Wert für $S_{B-\beta SN}$ (d.h. $I_{B-\beta SN}(101) / [0{,}5 \times (I_{B-\beta SN}(200) + I_{B-\beta SN}(120))]$) und somit das Verhältnis $S_{O-\beta SN} / S_{B-\beta SN}$ zunimmt.

In einer beispielhaften Ausführungsform genügt das Keramiksubstrat zumindest in dem Bereich der Aussparung der folgenden Bedingung:

$$0{,}4 \leq S_{O-\beta SN} \leq 2{,}0$$

wobei $S_{O-\beta SN}$ die oben angegebene Bedeutung hat.

In einer weiteren beispielhaften Ausführungsform ist folgende Bedingung erfüllt:

$$0{,}6 \leq S_{O-\beta SN} \leq 1{,}3$$

Das Röntgenbeugungsdiffraktogramm von β-Siliziumnitrid und die Indexierung der Röntgenbeugungsreflexe im Diffraktogramm sind dem Fachmann bekannt. Unter Verwendung von Cu-K$\alpha$-Strahlung erscheint beispielsweise der (101)-Reflex bei einem Beugungswinkel ($2\theta$) von 33,7 +/- 1,0°, der (200)-Reflex bei einem Beugungswinkel ($2\theta$) von 27,1 +/- 1,0° und der (120)-Reflex bei einem Beugungswinkel ($2\theta$) von 36.1 +/- 1.0°.

Optional kann das Keramiksubstrat noch ein oder mehrere Metalloxide enthalten. Diese wurden beispielsweise während der Herstellung des Keramiksubstrats als Sinterhilfsmittel zugegeben. Beispielsweise enthält das Keramiksubstrat eines oder mehrere der folgenden Oxide: Ein oder mehrere Erdalkalimetalloxide wie z.B. Magnesiumoxid, ein oder mehrere Übergangsmetalloxide (z.B. ein oder mehrere Seltenerdoxide wie Yttriumoxid oder Erbiumoxid), ein Siliziumoxid (z.B. $SiO_2$) oder ein Silikat.

Das Keramiksubstrat weist beispielsweise eine Dicke im Bereich von 0,1 mm bis 1,0 mm auf.

Auf der Vorderseite des Keramiksubstrats liegt eine Metallbeschichtung vor, die zumindest eine Aussparung aufweist, so dass eine Oberfläche des Keramiksubstrats durch die Aussparung freigelegt ist. Diese Metallbeschichtung wird nachfolgend auch als strukturierte Metallbeschichtung bezeichnet. Auf der strukturierten Metallbeschichtung können die Halbleiterbauelemente angebracht werden.

Optional liegt auf der Rückseite des Keramiksubstrats ebenfalls eine Metallbeschichtung vor. Diese rückseitige Metallbeschichtung kann optional ebenfalls zumindest eine Aussparung, durch die eine Oberfläche des Keramiksubstrats freigelegt ist, aufweisen. Um eine möglichst effiziente Wärmeabführung zu erzielen, kann es bevorzugt sein, dass die rückseitige Metallbeschichtung keine solche Aussparung aufweist.

Die auf der Vorderseite und optional der Rückseite des Keramiksubstrats vorliegende Metallbeschichtung ist beispielsweise eine Kupferbeschichtung oder eine Aluminiumbeschichtung. Die Metallbeschichtung weist beispielsweise eine Dicke im Bereich von 0,05 mm bis 1,5 mm, bevorzugter 0,2 mm bis 0,8 mm auf.

Sofern die Metallbeschichtung eine Kupferbeschichtung ist, weist diese beispielsweise einen Kupfergehalt von mindestens 97 Gew% auf.

Sofern die Metallbeschichtung eine Aluminiumbeschichtung ist, weist diese beispielsweise einen Aluminiumgehalt von mindestens 97 Gew% auf.

Die Metallbeschichtung kann über Verfahren, die dem Fachmann bekannt sind, auf die Vorderseite und gegebenenfalls die Rückseite des Keramiksubstrats aufgebracht werden.

Beispielsweise wird eine Metallfolie (z.B. eine Kupfer- oder Aluminiumfolie) durch ein Aktivlöten stoffschlüssig mit der Vorderseite des Keramiksubstrats verbunden.

Beim Aktivlöten wird beispielsweise bei einer Temperatur von etwa 600-1000°C eine Verbindung zwischen der Metallfolie und dem Keramiksubstrat unter Verwendung eines Aktivlots hergestellt. Aktivlote sind aufgrund ihrer Legierungszusammensetzung in der Lage, nichtmetallische, anorganische Werkstoffe wie z.B. Keramiksubstrate zu benetzen. Neben einer Hauptkomponente wie z.B. Kupfer, Silber und/oder Gold enthalten Aktivlote auch ein oder mehrere Aktivmetalle wie z.B. Hf, Ti, Zr, Nb, V, Ta oder Ce, die mit dem Verbindungspartner (z.B. dem Keramiksubstrat) reagieren können.

Bevorzugt liegt zwischen der Metallbeschichtung und der Vorderseite des Keramiksubstrats eine aus dem Aktivlöten resultierende Reaktionsschicht vor. Die Reaktionsschicht enthält beispielsweise ein oder mehrere Elemente $E_{RS}$, ausgewählt aus Hf, Ti, Zr, Nb, V, Ta und Ce, bevorzugt ausgewählt aus Hf, Ti, Zr, Nb und Ce, bevorzugter ausgewählt aus Hf, Ti und Zr. Besonders bevorzugt ist das Element $E_{RS}$ in der Reaktionsschicht Titan. Beispielsweise liegen die Elemente $E_{RS}$ in der Reaktionsschicht in Form eines Nitrids, Oxynitrids und/oder Silicids vor. Beispielsweise enthält die Reaktionsschicht die Elemente $E_{RS}$ in einer Gesamtmenge von mindestens 50 Gew%. Beispielsweise enthält die Reaktionsschicht die Nitride, Oxynitride und Silicide der Elemente ESR in einer Gesamtmenge von mindestens 70 Gew%, bevorzugter mindestens 85 Gew%. In einem Halbleitermodul der Leistungselektronik kann die Migration von Silber zu Problemen führen. Es kann daher bevorzugt sein, dass die Reaktionsschicht Silber in einem Anteil von nicht mehr als 5 Gew%, bevorzugter nicht mehr als 1 Gew% enthält oder sogar silberfrei ist.

Das Freilegen einer Oberfläche des Keramiksubstrats erfolgt beispielsweise in mehreren Schritten. Zunächst wird beispielsweise durch ein Ätzen die Metallbeschichtung abgetragen und die beim Aktivlöten gebildete Reaktionsschicht freigelegt. Anschließend wird die freigelegte Reaktionsschicht abgetragen, z.B. durch ein Ätzen oder eine Laserablation. Bevorzugt wird die freigelegte Reaktionsschicht unter Verwendung eines Ultrakurzpulslasers (z.B. eines IR-Picosekunden- oder Femtosekundenlasers) entfernt.

Um die durch die Aussparung voneinander getrennten Bereiche der Metallbeschichtung elektrisch voneinander zu isolieren, wäre es ausreichend, die Materialabtragung mit dem gepulsten Laserstrahl nur solange bzw. unter solchen Bedingungen durchzuführen, bis in den behandelten Bereichen das elektrisch leitfähige Material vollständig entfernt wurde, eine strukturelle Modifikation der β-Siliziumnitridphase an der Oberfläche des Keramiksubstrats aber vermieden wird.

Im Rahmen der vorliegenden Erfindung erfolgt jedoch durch eine Behandlung mit dem Ultrakurzpulslaser nicht nur ein Freilegen der Keramiksubstratoberfläche, sondern auch eine strukturelle Modifikation der β-Siliziumnitridphase an der Oberfläche des Keramiksubstrats. Als vorteilhaft für die Einstellung der erfindungsgemäßen Peakhöhenverhältnisse hat sich erwiesen, wenn der gepulste Laserstrahl mehrmals über die Oberfläche des Keramiksubstrats geführt wird, wobei die Laserpulse beispielsweise eine Pulsenergie von mindestens 10 μJ aufweisen.

Im Rahmen der vorliegenden Erfindung ist es auch möglich, die Keramiksubstratoberfläche zunächst durch einen ein- oder mehrstufigen Ätzprozess freizulegen und anschließend die freigelegte Keramiksubstratoberfläche mit dem Ultrakurzpulslaser (z.B. einem IR-Femto- oder Picosekundenlaser) zu behandeln, bis das erfindungsgemäße Peakhöhenverhältnis verwirklicht ist.

Aus Gründen der Verfahrenseffizienz kann es jedoch bevorzugt sein, den gepulsten Laserstrahl sowohl für Freilegung der Keramiksubstratoberfläche als auch die strukturelle Modifikation der β-Siliziumnitridphase an der Oberfläche des Keramiksubstrats zu nutzen.

Der Bereich der Aussparung, in dem das Keramiksubstrat das erfindungsgemäße Peakhöhenverhältnis zeigt, umfasst beispielsweise mindestens 50%, bevorzugter mindestens 70% der durch die Aussparung freigelegten Oberfläche des Keramiksubstrats oder kann sogar im Wesentlichen die gesamte durch die Aussparung freigelegte Oberfläche des Keramiksubstrats umfassen.

Eine freigelegte Oberfläche des Keramiksubstrats, die das erfindungsgemäße Peakhöhenverhältnis erfüllt, führt zu einer verbesserten Haftfestigkeit einer Vergussmasse auf dem Keramiksubstrat. Außerdem weist der erfindungsgemäße Metall-Keramik-Verbund weiterhin eine hohe mechanische Festigkeit auf.

Die vorliegende Erfindung betrifft außerdem ein Halbleitermodul, enthaltend

den oben beschriebenen Metall-Keramik-Verbund,

ein oder mehrere Halbleiterbauelemente.

Bevorzugt enthält das Halbleitermodul außerdem eine Vergussmasse, wobei die Vergussmasse die durch die Aussparung freigelegte Oberfläche des Keramiksubstrats des Metall-Keramik-Verbunds kontaktiert.

Vergussmassen für elektronische Bauelemente sind dem Fachmann bekannt. Die Vergussmasse enthält beispielsweise ein Polymer (z.B. ein thermoplastisches oder duroplastisches Polymer). Beispielsweise enthält die Vergussmasse ein optional ausgehärtetes Epoxidharz oder Silikonharz, ein Polyurethan oder einen anorganischen Zement (z.B. einen Phosphatzement).

**Messmethoden**

Bestimmung der Peakhöhen von Beugungsreflexen

Für die Bestimmung der Peakhöhen der Beugungsreflexe wurden Röntgenbeugungsmessungen in zwei Anordnungen durchgeführt.

In einer ersten Messung wurde die sogenannte Bragg-Brentano Geometrie verwendet. In dem mit dieser Geometrie aufgenommenen Diffraktogramm wurden die Peakhöhen der Reflexe (101), (200) und (120) bestimmt. Die Peakhöhen wurden auf die Peakhöhe des (120)-Reflexes normiert.

Eine weitere Messung wurde unter einem streifenden Einfall (3°) durchgeführt. In dem unter streifendem Einfall gemessenen Diffraktogramm wurden ebenfalls die Peakhöhen der Reflexe (101), (200) und (120) bestimmt. Die Peakhöhen wurden auf die Peakhöhe des (200)-Reflexes normiert.

Diffraktometer: Firma Stoe & Cie GmbH, 2-Kreis-Röntgenpulverdiffratometer, Typ Stadi P Fokussierung: Bragg-Brentano-Geometrie oder streifender Einfallswinkel (3°) mit Sekundarmonochromator und Szintillationszahler

Röntgenrohre: Kupferanode
Wellenlange: 1,54060 Ä Cu-K$\alpha$
Betriebsspannung: 40 kV
Betriebsstrom: 30mA
Mesbereich: 2Theta: 5° - 100° mit 0,02° Schritt; Omega: 2,5° - 50° 0,01step
Gl-Mesbereich: 2Theta: 5° - 100° mit 0,03°Schritt; Omega: 3°
Time/Step: 10 s

Justierung und Kalibration des Diffraktometer erfolgt mit dem NIST-Standard Si (640d). Die Proben für das XRD-Messung wurden im Bereich des freigelegten Keramiksubstrats in Form von 20x20x0,23 mm großen Plättchen herausgeschnitten.

Zusammensetzung der Haftvermittlungsschicht

Die Zusammensetzung der Haftvermittlungsschicht wird durch eine energiedispersive Röntgenspektroskopie (EDX), gekoppelt mit Rasterelektronenmikroskopie, bestimmt (REM-EDX).

Bei REM-EDX wird ein fokussierter Primär-Elektronenstrahl punktweise über die Probenoberfläche geführt (gerastert). Die gestreuten Elektronen werden mit einem Detektor erfasst, wobei die Elektronenzahl pro Bildpunkt ein mikroskopisches Abbild der Probenoberfläche in Graustufen ergibt. Zusätzlich regt der Primär-Elektronenstrahl die Probe zur Emission von charakteristischer Röntgenstrahlung an, wobei die Elemente in der Probe und deren Gewichtsanteil durch die Analyse des Energiespektrums mit einem EDX-Detektor bestimmt werden kann. Für die Untersuchung wird beispielsweise ein RasterElektronenmikroskop (JSM-6060 SEM, JEOL Ltd) mit einem Silizium Drift EDX Detektor (NORAN, Thermo Scientific Inc) und einer Analysesoftware (Pathfinder Mountaineer EDS System, zum Beispiel Version 2.8, Thermo Scientific Inc) verwendet. Für die RasterElektronenmikroskopie werden folgende Einstellungen verwendet: Vergrößerung: 1000fach, Beschleunigungsspannung = 15 kV, Arbeitsabstand = 10 mm, Spotgröße (50 - 60) (eingestellt, um 25% +/- 5% der Totzeit des EDX-Detektors zu erreichen). Das EDX-Spektrum wurde unter Verwendung der folgenden Einstellungen des EDX-Detektors erfasst: Live Time = 30 s, Rate = auto, Low Energy Cutoff = 100 keV, High Energy Cutoff = Auto (per REM-Beschleunigungsspannung).

Durch REM-EDX lässt sich die Zusammensetzung der Haftvermittlungsschicht sowohl in qualitativer Hinsicht (Detektion bestimmter Elemente und Phasen, z.B. eine in der Haftvermittlungsschicht vorliegende Metallnitridphase) als auch quantitativ bestimmen. Die Messung wird beispielsweise an mindestens 10 Stellen der Haftvermittlungsschicht durchgeführt.

**Beispiele**

Für die Beispiele wurden fünf Siliziumnitridkeramiksubstrate verwendet, die der gleichen Produktcharge entstammten. Das Siliziumnitrid liegt im Wesentlichen in der $\beta$-Phase vor. Für jedes dieser Substrate wurde das Verhältnis $S_{O\text{-}\beta SN} / S_{B\text{-}\beta SN}$ bestimmt. Die Ausgangssubstrate wiesen im Wesentlichen übereinstimmende Werte für das Verhältnis $S_{O\text{-}\beta SN} / S_{B\text{-}\beta SN}$ auf. $S_{O\text{-}\beta SN} / S_{B\text{-}\beta SN}$ der Ausgangssubstrate: 0,63 +/- 0,02

Vier der fünf Siliziumnitridsubstrate wurden durch identische Aktivlotverfahren unter den nachfolgend beschriebenen Bedingungen metallisiert.

Auf einer der Seiten des Keramiksubstrats wurde auf einer Fläche der Abmessung 168 mm $\times$ 130 mm eine Aktivlotpaste durch Siebdruck aufgebracht und für 15 Minuten bei 125°C vorgetrocknet. Die Aktivlotpaste bestand aus 67 Gewichtsprozent Kupferpulver, 19,8 Gewichtsprozent Zinnpulver und 3,7 Gewichtsprozent Titanhydrid und 9,5 Gewichtsprozent eines organischen Vehikels. Die Pastendicke nach der Vortrocknung betrug 25 +/- 5 $\mu$m. Anschließend wurde eine Kupferfolie aus sauerstofffreiem, hochleitfähigem Kupfer mit einer Reinheit von 99,99% und einer Abmessung von 170 mm $\times$ 132 mm $\times$ 0,3 mm auf die vorgetrocknete Paste gelegt. Danach wurde die so erzeugte Anordnung herumgedreht, die Paste gleichermaßen auf die gegenüberliegende Seite des Keramiksubstrats durch Siebdruck aufgebracht, vorgetrocknet und mit einer Kupferfolie bestückt, um eine Sandwichanordnung zu erhalten. Die Sandwichanordnung wurde mit einem Gewicht von 1 kg beschwert, bei einer Höchsttemperatur von 910°C für 20 Minuten gebrannt und anschließend auf Raumtemperatur abgekühlt, um einen unstrukturierten Metall-Keramik-Verbund zu erhalten. Aufgrund der Herstellung durch ein Aktivlöten liegt zwischen der Metallbeschichtung und dem Keramiksubstrat eine haftvermittelnde Reaktionsschicht vor. Diese enthält Titan (z.B. in Form eines Nitrids).

Jeder der vier Metall-Keramik-Verbunde wurde einer ersten Strukturierung unter Verwendung einer $CuCl_2$-haltigen Ätzlösung unterzogen. Dabei wurde auf der Vorderseite des Keramiksubstrats die Metallbeschichtung in den geätzten Bereichen im Wesentlichen vollständig abgetragen. Die aus dem Aktivlotverfahren resultierende Reaktionsschicht wurde allerdings durch die $CuCl_2$-haltige Ätzlösung nicht entfernt.

In Vergleichsbeispiel VB1 wurde die freigelegte Reaktionsschicht mit einer Ätzlösung, die Ammoniumfluorid, Fluorborsäure sowie Wasserstoffperoxid enthielt, entfernt.

In den erfindungsgemäßen Beispielen EB1 bis EB3 wurde die freigelegte Reaktionsschicht durch eine Laserbehandlung mit einem gepulsten Laserstrahl eines IR-Picosekundenlasers entfernt. Die Energie der Laserpulse betrug mindestens 12,5 $\mu$J. In Beispiel EB1 wurde die freigelegte Reaktionsschicht nur einmal mit dem gepulsten Laserstrahl entlang der vorgegebenen Scanlinien abgefahren. In den Beispielen EB2 und EB3 wurden die Scanlinien zweimal mit dem Laserstrahl abgefahren, wobei in EB3 eine höhere Pulsenergie als in EB2 verwendet wurde.

Für die freigelegten Keramikoberflächen der erfindungsgemäßen Beispiele EB1 bis EB3 sowie des Vergleichsbeispiels VB1 wurden jeweils $S_{O\text{-}\beta SN}$, $S_{B\text{-}\beta SN}$ und das Verhältnis $S_{O\text{-}\beta SN}/S_{B\text{-}\beta SN}$ gemessen. Anschließend wurde auf jede der freigelegten Keramikoberflächen eine Vergussmasse aufgebracht und die Haftfestigkeit bestimmt.

Auf das Siliziumnitridausgangssubstrat, das nicht metallisiert wurde, wurde ebenfalls eine Vergussmasse aufgebracht und die Haftfestigkeit bestimmt (Vergleichsbeispiel VB0).

Die Bestimmung der Haftfestigkeit erfolgte folgendermaßen:
Für die Bestimmung der Haftung einer Vergussmasse (Silikon) wurden aus jedem der freigelegten Bereiche des jeweiligen Keramiksubstrats zwei Plättchen (Größe der Plättchen: 20 $\times$ 20 $\times$ 0,32 mm) herausgeschnitten. Anschließend wurden die zwei Plättchen, die demselben Keramiksubstrat entnommen wurden, zu einem Prüfkörper mittels Silikons von Typ Sylgard 527 verklebt. Der Überlapp beider Plättchen betrug 1 cm, so dass die haftende Oberfläche immer 2cm$^2$ aufwies. Das Silikon wurde für 2h bei 125°C an Luft ausgehärtet. Jede Prüfkörper wurde dabei mit 50g Gewicht zusammengedrückt, um eine gleichmäßig dünne Silikonschicht zu erzeugen.

Die so hergestellten Prüfkörper wurden auf Scherfestigkeit getestet (Prüfmaschine: Modell zwicki500, ZwickRoell GmbH & Co. KG). Es wurde jeweils die maximale Scherkraft bestimmt.

Die Ergebnisse sind in der folgenden Tabelle 1 zusammengefasst.

Tabelle 1: $S_{O-\beta SN}$, $S_{B-\beta SN}$ und das Verhältnis $S_{O-\beta SN}/S_{S-\beta SN}$ der Siliziumnitridkeramiken sowie die Haftfestigkeit zwischen den Siliziumnitridoberflächen und einer Vergussmasse

| Beispiel | $S_{B-\beta SN}$ | $S_{O-\beta SN}$ | $S_{O-\beta SN} / S_{B-\beta SN}$ | Maximale Haftfestigkeit [N] |
|---|---|---|---|---|
| VB0 | 0,59 | 0,37 | 0,63 | 2,9 |
| VB1 | 0,51 | 0,36 | 0,71 | 2,8 |
| EB1 | 0,61 | 0,52 | 0,85 | 5,4 |
| EB2 | 0,65 | 0,70 | 1,08 | 15,1 |
| EB3 | 0,73 | 0,91 | 1,25 | 19,1 |

Die Behandlung der Siliziumnitridoberfläche mit dem gepulsten Laser bewirkte eine strukturelle Modifikation der β-Siliziumnitridphase an der Oberfläche des Keramiksubstrats, die sich an der Änderung des Intensitätsverhältnisses des (101)-Reflexes zu den (200) und (120)-Reflexen zeigt.

Diese Behandlung scheint in einem oberflächennahen Bereich des Keramiksubstrats eine relative Zunahme an länglichen β-Siliziumnitridkristalliten, die mit ihrer Längsachse im Wesentlichen parallel zur Dickenrichtung (d.h. senkrecht zur Vorder- oder Rückseite) des Keramiksubstrats orientiert sind, zu bewirken. Dies führt wiederum dazu, dass der Wert für $S_{O-\beta SN}$ eine stärkere Zunahme zeigt als der Wert für $S_{B-\beta SN}$ und somit das Verhältnis $S_{O-\beta SN} / S_{B-\beta SN}$ zunimmt.

Die Siliziumnitridkeramiken, die der erfindungsgemäßen Bedingung genügen, d.h. $S_{O-\beta SN} / S_{B-\beta SN} \geq 0,8$, zeigen eine deutlich bessere Haftfestigkeit hinsichtlich einer aufgebrachten Vergussmasse.

**Patentansprüche**

1.    Ein Metall-Keramik-Verbund, enthaltend

- ein Keramiksubstrat, das eine Vorderseite und eine Rückseite aufweist und β-Siliziumnitrid enthält,
- eine auf der Vorderseite des Keramiksubstrats vorliegende Metallbeschichtung,
wobei die Metallbeschichtung zumindest eine Aussparung aufweist und eine Oberfläche des Keramiksubstrats durch die Aussparung freigelegt ist,
wobei das Keramiksubstrat zumindest in dem Bereich der Aussparung der folgenden Bedingung genügt:

$$S_{O-\beta SN} / S_{B-\beta SN} \geq 0,8$$

wobei

$$S_{O-\beta SN} = I_{O-\beta SN}(101) / [0,5 \times (I_{O-\beta SN}(200) + I_{O-\beta SN}(120))]$$

$$S_{B-\beta SN} = I_{B-\beta SN}(101) / [0,5 \times (I_{B-\beta SN}(200) + I_{B-\beta SN}(120))]$$

$I_{O-\beta SN}(101)$, $I_{O-\beta SN}(200)$ und $I_{O-\beta SN}(120)$ die relativen Peakhöhen des (101)-, (200)- und (120)-Reflexes des β-Siliziumnitrids in einem Röntgenbeugungsdiffraktogramm, gemessen unter streifendem Einfall bei 3° mit Cu-Kα-Strahlung, sind, wobei die relativen Peakhöhen auf die Peakhöhe des (200)-Reflexes normiert sind, $I_{B-\beta SN}(101)$, $I_{B-\beta SN}(200)$ und $I_{B-\beta SN}(120)$ die relativen Peakhöhen des (101)-, (200)- und (120)-Reflexes des β-Siliziumnitrids in einem Röntgenbeugungsdiffraktogramm, gemessen mit Bragg-Brentano-Geometrie und Cu-Kα-Strahlung, sind, wobei die relativen Peakhöhen auf die Peakhöhe des (120)-Reflexes normiert sind.

2.    Der Metall-Keramik-Verbund nach Anspruch 1, wobei gilt:

$$2,2 \geq S_{O-\beta SN} / S_{B-\beta SN} \geq 0,8$$

3.    Der Metall-Keramik-Verbund nach Anspruch 1 oder 2, wobei folgende Bedingung erfüllt ist:

$$0,4 \leq S_{O-\beta SN} \leq 2,0$$

wobei $S_{O-\beta SN}$ die in Anspruch 1 angegebene Bedeutung hat.

4. Der Metall-Keramik-Verbund nach einem der vorstehenden Ansprüche, wobei die Metallbeschichtung eine Kupfer- oder Aluminiumbeschichtung ist.

5. Der Metall-Keramik-Verbund nach einem der vorstehenden Ansprüche, wobei zwischen dem Keramiksubstrat und der Metallbeschichtung eine Reaktionsschicht vorliegt, wobei die Reaktionsschicht ein oder mehrere Elemente $E_{RS}$, ausgewählt aus Ti, Hf, Zr, Nb, V, Ta und Ce, enthält.

6. Ein Halbleitermodul, enthaltend

   den Metall-Keramik-Verbund gemäß einem der Ansprüche 1-5,
   ein oder mehrere Halbleiterbauelemente.

7. Das Halbleitermodul nach Anspruch 6, außerdem enthaltend eine Vergussmasse, wobei die Vergussmasse die durch die Aussparung freigelegte Oberfläche des Keramiksubstrats des Metall-Keramik-Verbunds kontaktiert.

Europäisches
Patentamt

European
Patent Office

Office européen
des brevets

# EUROPÄISCHER RECHERCHENBERICHT

Nummer der Anmeldung

EP 24 21 4380

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | DE 10 2019 135099 A1 (ROGERS GERMANY GMBH [DE]) 24. Juni 2021 (2021-06-24) <br> * Absätze [0013], [0018], [0025] - [0027], [0039], [0042] * <br> * Abbildungen 1-3 * | 1-7 | INV.<br>C04B37/02<br>C04B41/53<br>H01L21/306<br>C04B41/00 |
| | - - - - - | | |
| X | EP 3 599 636 B1 (BOSCH GMBH ROBERT [DE]) 14. September 2022 (2022-09-14) <br> * Absätze [0014], [0025] - [0028]; Abbildungen 1,2 * | 1-7 | |
| | - - - - - | | |
| X | CN 111 704 479 A (OPPO GUANGDONG MOBILE TELECOMMUNICATIONS CO LTD) 25. September 2020 (2020-09-25) <br> * Absätze [0017], [0024] - [0026], [0035], [0053] - [0059] * <br> * Anspruch 9 * | 1-7 | |
| | - - - - - | | |
| X | US 2019/385926 A1 (NABA TAKAYUKI [JP] ET AL) 19. Dezember 2019 (2019-12-19) <br> * Absätze [0077] - [0087] * | 1-7 | RECHERCHIERTE SACHGEBIETE (IPC) |
| | - - - - - | | |
| A | US 2010/032143 A1 (DATTA MADHAV [US] ET AL) 11. Februar 2010 (2010-02-11) <br> * Absätze [0050] - [0051]; Anspruch 6; Abbildungen 9-11 * | 1-7 | C04B<br>H01L |
| | - - - - - | | |
| A | CN 117 043 934 A (ROGERS GERMANY GMBH) 10. November 2023 (2023-11-10) <br> * Ansprüche 4-5 * | 1-7 | |
| | - - - - - | | |

Der vorliegende Recherchenbericht wurde für alle Patentansprüche erstellt

| Recherchenort | Abschlußdatum der Recherche | Prüfer |
|---|---|---|
| Den Haag | 12. Februar 2025 | Sow, Eve |

KATEGORIE DER GENANNTEN DOKUMENTE

X : von besonderer Bedeutung allein betrachtet
Y : von besonderer Bedeutung in Verbindung mit einer
anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
nach dem Anmeldedatum veröffentlicht worden ist
D : in der Anmeldung angeführtes Dokument
L : aus anderen Gründen angeführtes Dokument

................................................................
& : Mitglied der gleichen Patentfamilie, übereinstimmendes
Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 24 21 4380

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

12-02-2025

| Im Recherchenbericht angeführtes Patentdokument | Datum der Veröffentlichung | Mitglied(er) der Patentfamilie | Datum der Veröffentlichung |
|---|---|---|---|
| DE 102019135099 A1 | 24-06-2021 | DE 102019135099 A1 | 24-06-2021 |
| | | EP 4021869 A1 | 06-07-2022 |
| | | JP 7400109 B2 | 18-12-2023 |
| | | JP 2023506558 A | 16-02-2023 |
| | | WO 2021122035 A1 | 24-06-2021 |
| EP 3599636 B1 | 14-09-2022 | DE 102018212272 A1 | 30-01-2020 |
| | | EP 3599636 A1 | 29-01-2020 |
| CN 111704479 A | 25-09-2020 | KEINE | |
| US 2019385926 A1 | 19-12-2019 | CN 110313064 A | 08-10-2019 |
| | | CN 118098990 A | 28-05-2024 |
| | | EP 3608951 A1 | 12-02-2020 |
| | | EP 4401128 A2 | 17-07-2024 |
| | | JP 7204637 B2 | 16-01-2023 |
| | | JP 7451638 B2 | 18-03-2024 |
| | | JP 2022177207 A | 30-11-2022 |
| | | JP WO2018173921 A1 | 30-01-2020 |
| | | US 2019385926 A1 | 19-12-2019 |
| | | US 2023154826 A1 | 18-05-2023 |
| | | WO 2018173921 A1 | 27-09-2018 |
| US 2010032143 A1 | 11-02-2010 | CN 102171378 A | 31-08-2011 |
| | | CN 102171897 A | 31-08-2011 |
| | | US 2010032143 A1 | 11-02-2010 |
| | | US 2010035024 A1 | 11-02-2010 |
| | | WO 2010017321 A1 | 11-02-2010 |
| | | WO 2010017327 A1 | 11-02-2010 |
| CN 117043934 A | 10-11-2023 | CN 117043934 A | 10-11-2023 |
| | | DE 102021107690 A1 | 29-09-2022 |
| | | EP 4315418 A1 | 07-02-2024 |
| | | JP 2024510808 A | 11-03-2024 |
| | | KR 20230150354 A | 30-10-2023 |
| | | US 2024178098 A1 | 30-05-2024 |
| | | WO 2022200406 A1 | 29-09-2022 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **T. OKUNO et al.** Si3N4 Substrates with Anisotropic Thermal Conductivity Suitable for Power Module Applications. *PCIM Europe digital days 2021; International Exhibition and Conference for Power Electronics, Intelligent Motion, Renewable Energy and Energy Management*, 2021, 1-5
- **N. CHASSERIO et al.** Ceramic Substrates for High-Temperature Electronic Integration. *Journal of Electronic Materials*, 2009, vol. 38, 164-174
- **K. HIRAO et al.** High Thermal Conductivity Silicon Nitride Ceramics. *Journal of the Korean Ceramic Society*, 2012, vol. 49, 380-384
- **Y. ZHOU et al.** Development of high-thermal-conductivity silicon nitride ceramics. *Journal ofAsian Ceramic Societies*, 2015, vol. 3, 221-229
- **X. ZHU ; Y. SAKKA**. Textured silicon nitride: processing and anisotropic properties. *Sci. Technol. Adv. Mater.*, 2008, vol. 9, 033001
- Aktivlöten. Brevier Technische Keramik, Verband der Keramischen Industrie. Fahner Verlag, 2003, 203-204
- **A. PÖNICKE et al.** Aktivlöten von Kupfer mit Aluminiumnitrid- und Siliziumnitridkeramik. *Keramische Zeitschrift*, 2011, vol. 63 (5), 334-342